**Europäisches Patentamt**

**European Patent Office**

**Office européen des brevets**

(19)

(11) **EP 1 643 635 A2**

(12) **EUROPEAN PATENT APPLICATION**

(43) Date of publication:
**05.04.2006 Bulletin 2006/14**

(51) Int Cl.:
*H03D 3/00* (2006.01)

(21) Application number: **05270049.9**

(22) Date of filing: **07.09.2005**

(84) Designated Contracting States:
**AT BE BG CH CY CZ DE DK EE ES FI FR GB GR HU IE IS IT LI LT LU LV MC NL PL PT RO SE SI SK TR**
Designated Extension States:
**AL BA HR MK YU**

(30) Priority: **17.09.2004 GB 0420642**

(71) Applicant: **MOTOROLA, INC.**
**Schaumburg, IL 60196 (US)**

(72) Inventors:
• **Shirazi, Gadi**
**67899, Tel Aviv (IL)**

• **Friedlander, Haim**
**67899, Tel Aviv (IL)**
• **Luzzatto, Ariel**
**67899, Tel Aviv (IL)**

(74) Representative: **McCormack, Derek James et al**
**Optimus**
**Grove House, Lutyens Close,**
**Chineham Court,**
**Basingstoke,**
**Hampshire RG24 8AG (GB)**

(54) **Demodulator for use in wireless communications and receiver, method and terminal using it**

(57)    A demodulator (100) for demodulating a frequency modulated RF signal (x(t)), includes an input signal path (101) for delivering an RF input signal, a local oscillator (111), connected to the input signal path a first mixer (107) for mixing an output reference signal from the local oscillator with an RF input signal to produce an in-phase component of the input received signal, a phase shifter (113), connected to the input signal path a second mixer (109) for mixing an output reference signal from the local oscillator via the phase shifter with the RF input signal to produce a quadrature component of the RF input signal; and an output signal processor (119) for producing an output demodulated information signal by producing a function of the in-phase and quadrature components; and wherein the demodulator is periodically operable in a quadrature phase error determination mode wherein the reference signals produced by the local oscillator have a frequency which is offset from the carrier frequency of an RF input signal.

Also described is a RF receiver, method and terminal using the demodulator.

*FIG. 1*

**Description**

**Field of the Invention**

This invention relates to a demodulator for use in wireless communications and a receiver, method and terminal using it. In particular, the invention relates to a demodulator capable of demodulating a frequency modulated (FM) RF (radio frequency) signal by resolution and use of in-phase (I) and quadrature-phase (Q) components of the modulated signal.

**Background of the Invention**

In many modern FM receivers, for example those used in RF communications between mobile stations, quadrature (I/Q) demodulators followed by digital processing have replaced the classical discriminator circuits as FM detectors. However, a known problem of such detectors is the presence of unwanted signal demodulation errors, which have an adverse effect on the audio quality of the detected signal. As illustrated later, such detectors can develop an error in relative phase between the I and Q components. These errors, sometimes referred to as 'quadrature imbalance', can cause a distortion in the resulting output audio signal. The distortion may be unacceptable to users particularly under conditions when the received signal is fading or has a low signal to noise ratio. The prior art does not provide a satisfactory solution to this problem.

Some receiver systems include imbalance tuning at the factory where the receiver is manufactured to measure and compensate for the quadrature phase error. However, this error changes with time (owing to temperature changes, for example) so the fixed compensation applied is not appropriate after a period of time.

**Summary of Invention**

In accordance with a first aspect of the present invention there is provided a demodulator for demodulating a frequency modulated RF signal, including an input signal path for delivering an RF input signal, a local oscillator, a first mixer connected to the input signal path for mixing an output reference signal from the local oscillator with an RF input signal to produce an in-phase component of the input received signal, a phase-shifted version of the local oscillator, a second mixer connected to the input signal path for mixing a phase-shifted version of the output reference signal from the local oscillator with the RF input signal to produce a quadrature component of the RF input signal; and an output digital signal processor for producing an output demodulated information signal by producing a function of the in-phase and quadrature components; and wherein the demodulator is periodically operable in a quadrature phase error determination mode wherein the reference signal produced by the local oscillator has a frequency which is offset from the carrier frequency of an RF input signal.

The demodulator may be periodically operable in the quadrature phase error determination mode when an RF input signal is an unmodulated signal. The input signal may be standard signal recognised by the demodulator or by a receiver in which it is incorporated. The standard signal may be a signal transmitted from a distant transmitter, e.g. for synchronisation purposes, e.g. before a call between terminals takes place.

The demodulator may include a programmable frequency synthesiser operable to control the frequency of the reference signals of the local oscillator, wherein the frequency synthesiser is operable to change the frequency of the local oscillator when the demodulator enters the quadrature phase error determination mode. Such programmable frequency synthesisers are well known per se in the art.

In the demodulator according the first aspect of the invention, the frequency offset in the quadrature phase error determination mode is desirably less than the bandwidth of the demodulator at the frequency of the RF input signal. The RF input signal may be a high frequency signal which has been received by a receiver incorporating the demodulator or it may be an intermediate frequency signal produced by down-conversion of a received signal.

The demodulator according to the first aspect of the invention may be operable to enter the quadrature phase error determination mode in periods alternating between periods when it operates in a normal detection mode in which it is tuned to a desired frequency of a modulated signal to be detected. The demodulator may conveniently be operable to enter the quadrature phase error determination mode in idle mode periods. Such periods occur when the demodulator is activated but no RF information carrying signal is being received by or transmitted by a terminal in which the demodulator is incorporated. Alternatively, or in addition, the demodulator may be in a terminal operating according to a TDMA (time division multiple access) timing structure or protocol and the demodulator may be operable to enter the quadrature phase error determination mode in idle or free time slots of the TDMA timing structure.

Where the demodulator includes a programmable frequency synthesiser operable to control the frequency of the reference signal of the local oscillator, the frequency synthesiser may conveniently be operable to change the frequency of the local oscillator when the demodulator changes between the quadrature phase error determination mode and the normal detection mode.

The demodulator according to the first aspect of the invention may include an error estimating signal processor which is operable in the quadrature phase error determination mode to estimate a quadrature phase error using the in-phase and quadrature components. The output signal processor and the error estimating signal processor may be combined in a single processor unit, e.g. a single digital microprocessor chip. The output signal processor may be operable to employ the estimated quadrature phase error to produce an output demodulated information signal. There may be an associated memory operable to store updated information relating to the estimated quadrature phase error for use by the output signal processor.

In one suitable example, the error estimating signal processor may be operable to form rectangular waveforms from the in-phase and in-quadrature components and to apply the rectangular waveforms to an exclusive OR gate. The error estimating signal processor may further include a duty cycle estimator to estimate the duty cycle of an output waveform from the exclusive OR gate. Such an output gives a measure of the estimated quadrature phase error.

According to the present invention in a second aspect there is provided a method of estimating a quadrature phase error of an RF demodulator which demodulator includes an input signal path for delivering an RF input signal, a local oscillator, connected to the input signal path a first mixer for mixing an output reference signal from the local oscillator with an RF input signal to produce an in-phase component of the input received signal, connected to the input signal path a second mixer for mixing a phase shifted output reference signal from the local oscillator with the RF input signal to produce a quadrature component of the RF input signal; and an output signal processor for producing an output demodulated information signal by producing a function of the in-phase and quadrature components; the method comprising periodically operating the demodulator in a quadrature phase error determination mode wherein the reference signals produced by the local oscillator of the demodulator have a frequency which is offset from the carrier frequency of an RF input signal.

According to the present invention in a third aspect there is provided a RF receiver or transceiver incorporating a demodulator according to the first aspect.

According to the present invention in a fourth aspect there is provided a terminal for wireless communications, the terminal incorporating a receiver or transceiver according to the third aspect. For example, the terminal may be a mobile station.

The present invention provides an improvement over the prior art in that it provides a convenient and relatively simple way of adaptively measuring the quadrature phase error in an FM demodulator and thereby of compensating for the error to allow minimal distortion to a received audio or other information signal.

Embodiments of the present invention will now be described by way of example with reference to the accompanying drawings, in which:

**Brief Description of the Drawings**

FIG. 1 is a schematic block circuit diagram of a FM demodulator which may be adapted in accordance with an embodiment of the invention.

FIG. 2 is a schematic block circuit diagram of part of a signal processor of the circuit shown in FIG. 1.

FIG. 3 is a waveform diagram illustrating operation of the signal processor part shown in Fig. 2.

FIG. 4 is a waveform diagram further illustrating operation of the signal processor part shown in Fig. 2.

**Description of embodiments of the invention**

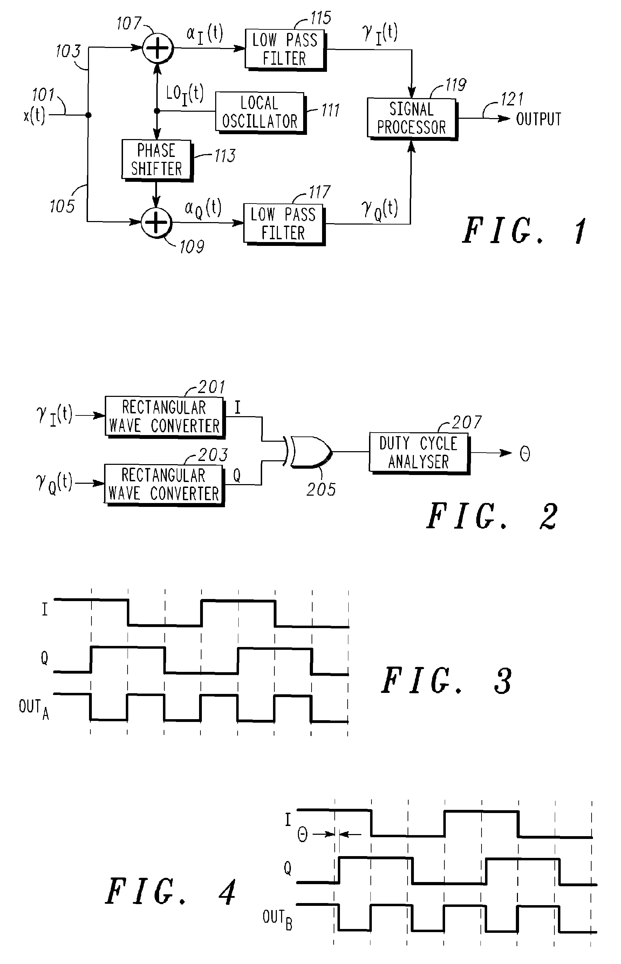

FIG. 1 shows a FM demodulator 100 embodying the present invention. An incoming FM signal x(t) is delivered via an input path 101 having branched connections 103, 105 respectively to two mixers 107, 109. A local oscillator 111 generates a reference signal which is applied to the mixer 107 where it is multiplied with the input signal x(t). A phase shifter 113 also generates a reference signal by shifting the phase of the output reference signal of the local oscillator 111 by a nominal value of 90 degrees. This phase shifted reference signal is applied to the mixer 109 where it is multiplied with the input signal x(t). An output signal from the mixer 107 is passed through a low pass filter (LPF) 115 to produce an output in-phase component signal and an output signal from the mixer 109 is passed through a low pass filter (LPF) 117 to produce an output quadrature-phase component signal. The output in-phase and quadrature-phase component signals are delivered to a signal processor 119 which processes the signals as described further below to provide an audio information signal 121. The information of the output signal 121 is typically speech or other audio information although it could alternatively be data or picture or video information.

An analysis of the demodulator 100 is as follows.

Firstly, assume that the signal x(t) at the input to the quadrature demodulator 100 is an FM signal and, operating in a normal detection mode, the carrier of x(t) resides at an angular frequency $\omega_C$. The signal x(t) is given by:

$$x(t) = A_C \cos[\omega_C t + \phi_{FM}(t)] = A_C \left\{ \cos(\omega_C t) \cos[\phi_{FM}(t)] - \sin(\omega_C t) \sin[\phi_{FM}(t)] \right\}$$

where

$$\phi_{FM}(t) = k_{FM} \int^t s(\tau) d\tau$$

and where $k_{FM}$ is the modulation index and s(t) is the information signal.

The local oscillator signals produced by the local oscillator 111 and phase shifter 113 are in this case respectively:

$$LO_I(t) = \cos(\omega_C t) \qquad LO_Q(t) = -\sin(\omega_C t)$$

The unfiltered in-phase product $\alpha_I(t)$ is:

$$a_I(t) = LO_I(t) \cdot x(t) = \cos(\omega_C t) \cdot A_C \left\{ \cos(\omega_C t) \cos[\phi_{FM}(t)] - \sin(\omega_C t) \sin[\phi_{FM}(t)] \right\}$$

By using the relationships:

$$\cos^2(\alpha) = \frac{1}{2} + \frac{1}{2}\cos(2\alpha) \qquad \sin(\alpha) \cdot \cos(\alpha) = \frac{1}{2}\sin(2\alpha)$$

we obtain:

$$a_I(t) = \frac{A_C}{2} \left\{ [1 + \cos(2\omega_C t)] \cdot \cos[\phi_{FM}(t)] - \sin(2\omega_C t) \cdot \sin[\phi_{FM}(t)] \right\}$$

The low pass filter 115 removes the high frequency components, yielding:

$$y_I(t) = \frac{A_C}{2} \cos[\phi_{FM}(t)]$$

The unfiltered quadrature-phase product $\alpha_Q(t)$ is given by:

$$a_Q(t) = LO_Q(t) \cdot x(t) = -\sin(\omega_C t) \cdot A_C \left\{ \cos(\omega_C t) \cos[\phi_{FM}(t)] - \sin(\omega_C t) \sin[\phi_{FM}(t)] \right\}$$

By using the relationships:

$$\sin^2(\alpha) = \frac{1}{2} - \frac{1}{2}\cos(2\alpha) \qquad \sin(\alpha) \cdot \cos(\alpha) = \frac{1}{2}\sin(2\alpha)$$

we obtain:

$$a_Q(t) = \frac{A_C}{2} \left\{ -\sin(2\omega_C t)\cos[\phi_{FM}(t)] + [1 - \cos(2\omega_C t)]\sin[\phi_{FM}(t)] \right\}$$

The low pass filter 117 removes the high frequency components, yielding:

$$y_Q(t) = \frac{A_C}{2}\sin[\phi_{FM}(t)]$$

Noting that the following relationship exists,

$$\frac{y_Q(t)}{y_I(t)} = \frac{\sin[\phi_{FM}(t)]}{\cos[\phi_{FM}(t)]} = \tan[\phi_{FM}(t)]$$

the in-phase and quadrature-phase products $y_I(t)$ and $y_Q(t)$ after low pass filtering can then be digitally processed to reconstruct an information signal $\hat{s}(t)$ present in the received signal x(t) and to be extracted:

$$\hat{s}(t) = \frac{d}{dt}\left\{ \frac{1}{k_{FM}}\hat{\phi}_{FM}(t) \right\} = \frac{d}{dt}\left\{ \frac{1}{k_{FM}}\arctan\left[ \frac{y_Q(t)}{y_I(t)} \right] \right\}$$

Thus, the signal processor 119 receives as inputs the signals $y_I(t)$ and $y_Q(t)$ and processes these according to the above equation to reconstruct the information signal $\hat{s}(t)$.

When reconstructing the phase angle, the arctangent function operated by the processor 119 can determine the correct quadrant by noting the signs of the in-phase and quadrature-phase signals processed:

$$y_I > 0, y_Q > 0 \;\Rightarrow\; 0 < \phi_{FM}(t) < \frac{\pi}{2}$$

$$y_I < 0, y_Q > 0 \;\Rightarrow\; \frac{\pi}{2} < \phi_{FM}(t) < \pi$$

$$y_I < 0, y_Q < 0 \implies -\pi < \phi_{FM}(t) < -\frac{\pi}{2}$$

$$y_I > 0, y_Q < 0 \implies -\frac{\pi}{2} < \phi_{FM}(t) < 0$$

In practice, it must be assumed that a phase error (imbalance) exists in the output of the quadrature-phase phase shifter 113 so that the output of this phase shifter may be represented by :

$$LO_Q(t) = -\sin(\omega_C t + \theta)$$

The quadrature-phase product becomes:

$$a_Q(t) = -\sin(\omega_C t + \theta) \cdot A_C \left\{ \cos(\omega_C t) \cos[\phi_{FM}(t)] - \sin(\omega_C t) \sin[\phi_{FM}(t)] \right\}$$

By using the relationship:

$$\sin(\omega_C t + \theta) = \sin(\omega_C t)\cos(\theta) + \cos(\omega_C t)\sin(\theta)$$

we obtain the following product after filtering by the low pass filter 117:

$$y_Q(t) = \frac{A_C}{2}\left\{ \sin[\phi_{FM}(t)]\cos(\theta) - \cos[\phi_{FM}(t)]\sin(\theta) \right\} = \frac{A_C}{2}\sin[\phi_{FM}(t) - \theta]$$

We note that:

$$\frac{y_Q(t)}{y_I(t)} = \frac{\sin[\phi_{FM}(t)]\cos(\theta) - \cos[\phi_{FM}(t)]\sin(\theta)}{\cos[\phi_{FM}(t)]} = \cos(\theta)\tan[\phi_{FM}(t)] - \sin(\theta)$$

Therefore, there will be the following reconstruction error $\varepsilon(t)$ in calculating $\hat{s}(t)$ :

$$\hat{s}(t) = \frac{d}{dt}\left\{ \frac{1}{k_{FM}}\arctan\left[\frac{y_Q(t)}{y_I(t)}\right] \right\} = \frac{d}{dt}\left\{ \frac{1}{k_{FM}}\arctan\{\cos(\theta)\tan[\phi_{FM}(t)] - \sin(\theta)\} \right\} = s(t) + \varepsilon(t)$$

However, if θ is known, a correction algorithm may be employed by use of the following relationship:

$$\tan[\phi_{FM}(t)] = \frac{1}{\cos(\theta)}\left[\frac{y_Q(t)}{y_I(t)} + \sin(\theta)\right]$$

$$\hat{s}(t) = \frac{d}{dt}\left\{\frac{1}{k_{FM}}\arctan\left[\frac{1}{\cos(\theta)}\left[\frac{y_Q(t)}{y_I(t)} + \sin(\theta)\right]\right]\right\}$$

Thus, in practice the signal processor 119 operates to determine the phase error angle θ in a manner described later and then uses the determined value of θ in reconstructing $\hat{s}(t)$ allowing for the error ε(t) by applying the above equation.

In accordance with an embodiment of the invention, the demodulator 100 periodically enters a quadrature phase error determination mode. In this mode, a specific reference input carrier signal x(t) is found and a pre-determined offset is applied to the angular frequency of the output of the local oscillator 111 compared with the angular frequency of the carrier of the input signal x(t). This is used as a route to measuring θ in the following way.

Assume that the carrier of x(t) resides at an angular frequency $\omega_c + \omega_\Delta$, and has an arbitrary phase φ. The demodulator 100 is tuned, by suitable tuning of the local oscillator 111 to $\omega_c$.

In this case, the signals shown in FIG. 1 will be as follows:

$$x(t) = A_C \cos[(\omega_C + \omega_\Delta)t + \varphi] = A_C\{\cos(\omega_C t)\cos(\omega_\Delta t + \varphi) - \sin(\omega_C t)\sin(\omega_\Delta t + \varphi)\}$$

$$LO_I(t) = \cos(\omega_C t)\,; \quad LO_Q(t) = -\sin(\omega_C t + \theta) = -\sin(\omega_C t)\cos(\theta) - \cos(\omega_C t)\sin(\theta)$$

The filtered in-phase and quadrature-phase products produced by the low pass filters 115, 117 respectively are:

$$y_I(t) = \frac{A_C}{2}\cos(\omega_\Delta t + \varphi)$$

$$y_Q(t) = \frac{A_C}{2}\{\sin(\omega_\Delta t + \varphi)\cos(\theta) - \cos(\omega_\Delta t + \varphi)\sin(\theta)\} = \frac{A_C}{2}\sin(\omega_\Delta t + \varphi - \theta)$$

The signal processor 119 can compare the in-phase and quadrature-phase products $y_I(t)$ and $y_Q(t)$ after low pass filtering in order to extract θ using these relationships. One method of measuring θ in this way is to convert the in-phase and quadrature-phase products to rectangular waveforms, and then perform a XOR (exclusive OR) function between them. The duty cycle of the resulting waveform has a linear relationship to the phase error θ. This is illustrated in FIGs. 2 to 4 as follows.

FIG. 2 shows a suitable processing arrangement 200. In practice the arrangement is part of the processing functionality of the signal processor 119. An in-phase component (such as $y_I(t)$ referred to above) and a quadrature-phase component (such as $y_Q(t)$ referred to above) are converted to rectangular waves I, Q respectively by application to rectangular wave converters 201, 203. The respective outputs I, Q of the rectangular wave converters 201, 203 are applied to an exclusive OR gate 205. A square wave output 'out' is produced by the exclusive OR gate 205 and its duty cycle is measured by a duty cycle analyser 207. The output of the duty cycle analyser 207 is a measure of the phase error θ.

Processing by the arrangement shown in FIG. 2 is illustrated in FIGs. 3 and 4.

Firstly, FIG. 3 illustrates the situation when the phase error is zero. The waveform I and the waveform Q are exactly 90 degrees out of phase. The output of the exclusive OR gate 205 is shown as a waveform 'out$_A$' in FIG. 3. The waveform 'out$_A$' is determined by the analyser 207 to have a duty cycle of exactly 50 per cent. The duty cycle is a known measure of the degree of overlap between the waveforms I and Q. This is a correct duty cycle and the analyser therefore produces an output zero.

FIG. 4 illustrates the situation when the phase error is a small but finite value $\theta$. The waveform I and the waveform Q are out of phase by an amount which differs by an error $\theta$ from 90 degrees. This is indicated on the waveform Q in FIG. 4. The output of the exclusive OR gate 205 is shown as a waveform 'out$_B$' in FIG. 3. The waveform 'out$_B$' is determined by the analyser 207 to have a duty cycle which differs from 50 per cent by an amount proportional to $\theta$. The analyser therefore produces an output equal to $\theta$.

Thus, during operation in the normal reception mode by the receiver in which the demodulator 100 is incorporated, the local oscillator 111 is tuned to the desired channel in which the signal to be detected resides. However, when the receiver is switched (by a signal processor acting as a controller) periodically to the quadrature phase error determination mode, tuning of the local oscillator 111 is switched to be near the frequency of a known unmodulated carrier, but offset by a small pre-determined amount which is less than the bandwidth of the receiver baseband. This action can be performed during an idle mode (i.e. when no reception or transmission of an information carrying signal is required), or during idle slots in a TDMA time structure. For example, the receiver may be tuned to the desired offset frequency by means of programming a synthesiser that generates the local oscillator signal, the synthesiser being controlled by a controller.

Where the invention is used in a radio (e.g. a radio telephone receiver), a memory of the radio may be programmed following manufacture to store a table of initial quadrature phase errors values versus RF frequency. During operation of the radio receiver, the quadrature phase errors will change with time. Thus, updated quadrature phase error information may be gathered in use as described above and used to provide suitable compensation to maintain a suitable quality of output signal. The updated quadrature phase error information may be stored in a memory of the radio receiver to replace the previously stored information. In this way, the quadrature phase error information beneficially is adaptively measured and updated information is used in detection of information carrying signals.

In contrast to the prior art, the procedures described above provide a convenient and relatively simple way of adaptively measuring the quadrature phase error in an FM demodulator and thereby of compensating for the error to allow minimal distortion to a received audio or other information signal.

The demodulator 100 may be used in a FM receiver comprising an antenna, the demodulator 100 and a baseband signal processor. Such a receiver circuit may also include a high frequency RF signal processor which downconverts a received RF signal to provide an input signal x(t) to the demodulator 100 at an intermediate frequency. The receiver may be used in a conventional mobile station for FM wireless communication. The receiver may be part of a transceiver which has some common transmitter and receiver components. Such a mobile station will include in addition to the transceiver and signal processor and memory typically also a battery, a user interface (e.g. keyboard), a user display and input and output transducers such as a speaker and a microphone.

**Claims**

1. A demodulator (100) for demodulating a frequency modulated RF signal, including an input signal path (101) for delivering an RF input signal, a local oscillator (111), a first mixer (107) connected to the input signal path for mixing an output reference signal from the local oscillator with an RF input signal to produce an in-phase component of the input received signal, connected to the input signal path a second mixer (109) for mixing a phase-shifted version of the output reference signal from the local oscillator with the RF input signal to produce a quadrature component of the RF input signal; and an output digital signal processor (119) for producing an output demodulated information signal by producing a function of the in-phase and quadrature components; and wherein the demodulator is periodically operable in a quadrature, phase error determination mode wherein the reference signal produced by the local oscillator has a frequency which is offset from the carrier frequency of an RF input signal.

2. A demodulator according to claim 1 wherein the demodulator is periodically operable in the quadrature phase error determination mode when an RF input signal is an unmodulated signal.

3. A demodulator according to claim 1 or claim 2 and including a programmable frequency synthesiser operable to control the frequency of the reference signals of the local oscillator, wherein the frequency synthesiser is operable to change the frequency of the local oscillator when the demodulator enters the quadrature phase error determination mode.

4. A demodulator according to any one of the preceding claims, wherein the frequency offset is less than the bandwidth of the demodulator at the frequency of the RF input signal.

5. A demodulator according to any one of the preceding claims wherein the demodulator is operable to enter the quadrature phase error determination mode in periods alternating between periods when it operates in a normal detection mode in which it is tuned to a desired frequency of a modulated signal to be detected.

6. A demodulator according to any one of the preceding claims wherein the demodulator is operable to enter the quadrature phase error determination mode in idle mode periods.

7. A demodulator according to any one of the preceding claims wherein the demodulator is operable to enter the quadrature phase error determination mode in idle time slots of a TDMA timing structure.

8. A demodulator according to any one of claims 5 to 7 and including a programmable frequency synthesiser operable to control the frequency of the reference signals of the local oscillator, wherein the frequency synthesiser is operable to change the frequency of the local oscillator when the demodulator changes between the quadrature phase error determination mode and the normal detection mode.

9. A demodulator according to any one the preceding claims and including an error estimating signal processor which is operable in the quadrature phase error determination mode to estimate a quadrature phase error using the in-phase and quadrature components.

10. A demodulator according to claim 9 wherein the output signal processor and the error estimating signal processor are combined in a single processor unit.

11. A demodulator according to claim 9 or claim 10 wherein the output signal processor is operable to employ the estimated quadrature phase error to produce a corrected output demodulated information signal.

12. A demodulator according to claim 11 including an associated memory operable to store updated information relating to the estimated quadrature phase error for use by the output signal processor.

13. A demodulator according to any one of the preceding claims 9 to 12 wherein the error estimating signal processor is operable to form rectangular waveforms from the in-phase and quadrature components and to apply the rectangular waveforms to an exclusive OR gate.

14. A demodulator according to claim 13 and wherein the error estimating signal processor includes a duty cycle estimator to estimate the duty cycle of an output waveform from the exclusive OR gate.

15. A method of estimating a quadrature phase error of an RF demodulator which demodulator includes an input signal path for delivering an RF input signal, a local oscillator, connected to the input signal path a first mixer for mixing an output reference signal from the local oscillator with an RF input signal to produce an in-phase component of the input received signal, connected to the input signal path a second mixer for mixing a phase shifted output reference signal from the local oscillator with the RF input signal to produce a quadrature component of the RF input signal; and an output signal processor for producing an output demodulated information signal by producing a function of the in-phase and quadrature components; the method comprising periodically operating the demodulator in a quadrature phase error determination mode wherein the reference signals produced by the local oscillator of the demodulator have a frequency which is offset from the carrier frequency of an RF input signal.

16. A RF receiver or transceiver incorporating a demodulator according to any one of the preceding claims 1 to 15.

17. A mobile station for use in wireless communications incorporating a RF receiver or transceiver according to claim 16.

*FIG. 1*

*FIG. 2*

*FIG. 3*

*FIG. 4*